# EUROPÄISCHE PATENTSCHRIFT

(11) **EP 1 770 835 B1**
(45) Veröffentlichungstag und Bekanntmachung des Hinweises auf die Patenterteilung: **08.06.2011**
(21) Anmeldenummer: 06020602.6
(22) Anmeldetag: 29.09.2006
(51) Int. Cl.: H01S 5/183, H01S 5/14, H01S 5/024, H01S 5/06, H01S 5/04, H04N 9/31

(54) **Oberflächenemittierendes Halbleiterlaser-Bauelement und optische Projektionsvorrichtung mit solch einem oberflächenemittierenden Halbleiterlaser-Bauelement**
Surface emitting semiconductor laser device and optical projection device comprising the same
Dispositif laser semi-conducteur à émission de surface et dispositif de projection optique l'utilisant

(30) Priorität: 30.09.2005 DE 102005047150; 06.12.2005 DE 102005058237
(43) Veröffentlichungstag der Anmeldung: 04.04.2007
(73) Patentinhaber: OSRAM Opto Semiconductors GmbH, 93055 Regensburg (DE)
(72) Erfinder: Lutgen, Stephan, 93047 Regensburg (DE)
(74) Vertreter: Epping - Hermann - Fischer

(56) Entgegenhaltungen:
- EP-A- 1 560 306
- GB-A- 2 399 942
- US-A1- 2005 036 528
- HASTIE J E ET AL: "0.5-W SINGLE TRANSVERSE-MODE OPERATION OF AN 850-NM DIODE-PUMPED SURFACE-EMITTING SEMICONDUCTOR LASER" IEEE PHOTONICS TECHNOLOGY LETTERS, IEEE SERVICE CENTER, PISCATAWAY, NJ, US, Bd. 15, Nr. 7, Juli 2003 (2003-07), Seiten 894-896, XP001175831 ISSN: 1041-1135
- STEEGMULLER U ET AL: "High green frequency converted semiconductor laser for projection displays" DIGEST OF TECHNICAL PAPERS - SID INTERNATIONAL SYMPOSIUM; 2005 SID INTERNATIONAL SYMPOSIUM, BOSTON, MA, USA, 25-27 MAY 2005, Bd. 36, Nr. 2, 25. Mai 2005 (2005-05-25), Seiten 1608-1609, XP001244411
- LINDBERG H ET AL: "Single-frequency operation of a high-power, long-wavelength semiconductor disk laser" OPTICS LETTERS OPT. SOC. AMERICA USA, Bd. 30, Nr. 17, 1. September 2005 (2005-09-01), Seiten 2260-2262, XP009076932 ISSN: 0146-9592
- ALFORD W J ET AL: "High power and good beam quality at 980 nm from a vertical external-cavity surface-emitting laser" JOURNAL OF THE OPTICAL SOCIETY OF AMERICA - B, OPTICAL SOCIETY OF AMERICA, WASHINGTON, US, Bd. 19, Nr. 4, 1. April 2002 (2002-04-01), Seiten 663-666, XP002305264 ISSN: 0740-3224
- HÄRKÖNEN A ET AL: "4 W single-transverse mode VECSEL utilising intra-cavity diamond heat spreader" ELECTRONICS LETTERS, IEE STEVENAGE, GB, Bd. 42, Nr. 12, 8. Juni 2006 (2006-06-08), Seiten 693-694, XP006026815 ISSN: 0013-5194

## Beschreibung

Es wird ein oberflächenemittierendes Halbleiterlaser-Bauelement angegeben. Darüber hinaus wird eine optische Projektionsvorrichtung mit solch einem oberflächenemittierenden Halbleiterlaser-Bauelement angegeben.

Die Druckschrift Hastie J. et al.: "0.5-W Single Transverse-Mode Operarion of an 850-nm Diode-Pumped Surface-Emitting Semiconductor Laser", IEEE Photonics Technology Letters, Vol. 15, Nr. 7, July 2003, pp 894-896, beschreibt ein oberflächenemittierendes Halbleiterlaser-Bauelement mit einer SiC Wärmesenke, die sich in optischem Kontakt mit dem Halbleiterkörper eines oberflächenemittierenden Halbleiterlasers befindet.

Die Druckschrift EP 1560306 A2 beschreibt einen oberflächenemittierenden Halbleiterlaser mit Interferenzfilter.

Die Druckschrift Lindberg H. et al.: "Single-frequency operation of a high-power, long-wavelength semiconductor disk laser", Optics Letters, Bd. 30, Nr. 17, 1. September 2004, pp. 2260-2262, beschreibt einen optisch gepumpten Halbleiter-Scheibenlaser, mit einer Diamant-Wärmesenke, die auf den Scheibenlaser aufgebracht ist.

Die Druckschrift US 2005/0036528A1 beschreibt einen optisch gepumpten, vertikal emittierenden Halbleiterlaser.

Eine zu lösende Aufgabe besteht darin, ein oberflächenemittierendes Halbleiterlaser-Bauelement mit einer zeitlich besonders stabilen Laseremission anzugeben.

Diese Aufgabe wird mit einem Halbleiterlaser-Bauelement gemäß Patentanspruch 1 gelöst.

Es wird ein oberflächenemittierendes Halbleiterlaser-Bauelement angegeben. Gemäß zumindest einer Ausführungsform des oberflächenemittierenden Halbleiterlaser-Bauelements umfasst das Bauelement einen Halbleiterkörper mit einer Halbleiterschichtenfolge. Die Halbleiterschichtenfolge umfasst unter anderem eine zur Strahlungserzeugung geeignete Schichtenfolge, die z. B. einen pn-Übergang, eine Einfach-Quantentopfstruktur oder eine Mehrfach-Quantentopfstruktur enthalten kann.

Der Halbleiterkörper umfasst vorzugsweise ferner eine reflektierende Schicht oder Schichtenfolge, die geeignet ist, zumindest einen Teil der in der zur Strahlungserzeugung vorgesehenen Schichtenfolge erzeugten elektromagnetischen Strahlung zu reflektieren. Die reflektierende Schichtenfolge umfasst dazu z. B. einen Bragg-Spiegel. In der strahlungserzeugenden Schichtenfolge im Betrieb des Halbleiterlasers erzeugte elektromagnetische Strahlung tritt durch eine Strahlungsdurchtrittsfläche aus dem Halbleiterkörper aus. Die Strahlungsdurchtrittsfläche ist dabei durch eine Hauptfläche des Halbleiterkörpers gebildet, die auf einer der reflektierenden Schichtenfolge abgewandten Seite der strahlungserzeugenden Schichtenfolge angeordnet ist.

Das oberflächenemittierende Halbleiterlaser-Bauelement weist einen weiteren Spiegel auf, der extern, d. h. vom Halbleiterkörper entfernt, angeordnet ist. Der externe Spiegel und die reflektierende Schichtenfolge des Halbleiterkörpers bilden einen Resonator des Halbleiterlaser-Bauelements, in dem in der strahlungserzeugenden Schichtenfolge verstärkte elektromagnetische Strahlung umlaufen kann.

Das oberflächenemittierende Halbleiterlaser-Bauelement weist ein Wärmeleitelement auf, das sich mit der Strahlungsdurchtrittsfläche des Halbleiterkörpers in thermischem Kontakt befindet. Das Wärmeleitelement ist also im durch die reflektierende Schichtenfolge und den externen Spiegel gebildeten Resonator des oberflächenemittierenden Halbleiterlaser-Bauelements angeordnet. Das Wärmeleitelement stellt dabei einen Wärmespreizer dar, der im Betrieb des Halbleiterlaser-Bauelements erzeugte Wärme aufnimmt und an die Umgebung abgibt. Das Wärmeleitelement ist zumindest für einen Teil der im Resonator umlaufenden Laserstrahlung durchlässig. Das heißt, das Wärmeleitelement ist vorzugsweise zumindest im Frequenzbereich von in der strahlungserzeugenden Schichtenfolge erzeugten elektromagnetischen Strahlung zum Teil transparent.

Ferner weist das Wärmeleitelement frequenzselektive Eigenschaften auf. Dazu handelt es sich bei dem Wärmeleitelement um ein Etalon. Aufgrund des Etalon-Effekts des im Resonator angeordneten Wärmeleitelements können im Resonator mehrere longitudinale Moden anschwingen, deren Modenabstand dann von der Dicke des Wärmeleitelements abhängig ist. Aufgrund der frequenzselektiven Eigenschaften des Wärmeleitelements stellen sich spektral schmalbandige Moden der im Resonator umlaufenden Laserstrahlung ein. Das Wärmeleitelement füllt den Resonator dabei vorzugsweise nicht vollständig aus.

Das oberflächenemittierende Halbleiterlaser-Bauelement weist ferner ein optisches Bandpassfilter auf, das im Resonator des Halbleiterlaser-Bauelements angeordnet ist oder integraler Bestandteil des Resonators ist. Das optische Bandpassfilter ist geeignet, vorgebbare Resonatormoden zu unterdrücken. Dazu ist das Bandpassfilter beispielsweise für elektromagnetische Strahlung eines bestimmten Frequenzbereichs durchlässig oder reflektierend ausgebildet. Lediglich die Resonatormoden, deren Frequenzen sich in diesem Frequenzbereich befinden, können dann im Resonator anschwingen. Das heißt, der Bandpass des optischen Bandpassfilters ist so gewählt, dass nur bestimmte Resonatormoden anschwingen können. Der Bandpass ist so gewählt, dass genau eine Resonatormode - beispielsweise die transversale Grundmode TEM₀₀ - anschwingen kann.

Das Halbleiterlaser-Bauelement umfasst einen Resonator, einen Halbleiterkörper, der eine zur Strahlungserzeugung vorgesehene Schichtenfolge umfasst, ein transparentes, frequenzselektives Wärmeleitelement, das sich mit der Strahlungsdurchtrittsfläche des Halbleiterkörpers in thermischem Kontakt befindet, und ein optisches Bandpassfilter, das geeignet ist, vorgegebene Resonatormoden zu unterdrücken.

Dem oberflächenemittierenden Halbleiterlaser-Bauelement liegt dabei unter anderem die Idee zugrunde, dass ein frequenzselektives, optisches Element im Resonator - ein Etalon - als Wärmeleitelement oder Wärmespreizer Verwendung findet und damit neben seinen optischen Eigenschaften auch das thermische Verhalten des Bauelements positiv beeinflusst. Ferner ermöglicht es das frequenzselektive Wärmeleitelement, dass spektral besonders schmalbandige transversale Moden im Laserresonator anschwingen, die voneinander beabstandet sind. Zur Auswahl einer dieser Moden, d. h. zur Unterdrückung der verbleibenden Moden, findet dann ein relativ breitbandiges Bandpassfilter Verwendung. Ein solches breitbandiges Bandpassfilter ist besonders einfach und damit besonders kostengünstig herstellbar.

Gemäß zumindest einer Ausführungsform enthält oder besteht das Wärmeleitelement aus einem der folgenden Materialien: Diamant, Siliziumkarbid (SiC). Das Wärmeleitelement weist dabei vorzugsweise eine Dicke in Richtung der aus dem Halbleiterkörper austretenden elektromagnetischen Strahlung von 30 µm bis 60 µm auf. Das Wärmeleitelement ist vorzugsweise als Diamant- oder Siliziumkarbid-Etalon ausgebildet. Das heißt, es kann entsprechend reflektierend ausgebildet sein.

Gemäß zumindest einer Ausführungsform des oberflächenemittierenden Halbleiterlaser-Bauelements ist ferner ein optisch nicht linearer Kristall im Resonator des Halbleiterlaser-Bauelements angeordnet.

Vorzugsweise ist der optisch nicht lineare Kristall zur Frequenzkonversion zumindest eines Teils der im Resonator umlaufenden Laserstrahlung vorgesehen.

Gemäß zumindest einer Ausführungsform der Laservorrichtung umfasst der optisch nicht lineare Kristall zumindest einen der folgenden Kristalle: Lithiumtriborat z.B. LiB₃O₅ (LBO), Wismuttriborat z.B. BiB₃O₆ (BiBO), Kaliumtitanylphosphat KTiOPO₄ (KTP), magnesiumoxiddotiertes kongruentes Lithiumniobat z.B. MgO:LiNbO₃ (MgO:LN), magnesiumoxiddotiertes stöchiometrisches Lithiumniobat z.B. MgO:s-LiNbO₃ (MgO:SLN), magnesiumoxiddotiertes stöchiometrisches Lithiumtantalat z.B. MgO:LiTaO₃ (MgO:SLT), stöchiometrisches LiNbO₃ (SLN), stöchiometrisches LiTaO₃ (SLT), RTP (RbTiOPO₄), KTA (KTiOAsO₄), RTA (RbTiOAsO₄), CTA (CsTiOAsO₄).

Bevorzugt ist der optisch nicht lineare Kristall zur Frequenzverdoppelung der ihn durchtretenden Strahlung geeignet.

Abgesehen von den hier aufgeführten Kristallen zur Frequenzkonversion können aber auch andere Kristalle oder Materialien, die zur Frequenzkonversion geeignet sind, alternativ oder zusätzlich im Resonator des Lasers angeordnet sein.

Das hier beschriebene oberflächenemittierende Halbleiterlaser-Bauelement macht sich dabei unter anderem die Idee zunutze, dass durch das Zusammenwirken von frequenzselektivem Wärmeleitelement und optischem Bandpassfilter ein stabiler Single-Moden-Betrieb des oberflächenemittierenden Halbleiterlaser-Bauelements ermöglicht ist. Die so erzeugte Laserstrahlung kann dann mit besonders hoher Effizienz durch den optisch nicht linearen Kristall frequenzkonvertiert werden. Insbesondere wird durch das frequenzselektive Wärmeleitelement und das optische Bandpassfilter ein Modenspringen (mode hopping) unterdrückt.

Das Bandpassfilter ist als Beschichtung ausgebildet. Das Bandpassfilter ist beispielsweise als Beschichtung auf ein im Resonator angeordnetes Element - wie z. B. den nicht linearen optischen Kristall - aufgebracht. Die Beschichtung ist dabei als Antireflexionsbeschichtung ausgeführt.

Gemäß zumindest einer Ausführungsform des oberflächenemittierenden Halbleiterlaser-Bauelements weist das Bandpassfilter eine Bandbreite von > 2 nm auf. Das heißt, das Bandpassfilter ist für einen Wellenlängenbereich > 2 nm durchlässig. Das hier beschriebene oberflächenemittierende Halbleiterlaser-Bauelement macht sich dabei unter anderem die Erkenntnis zunutze, dass ein solcher, relativ breiter Bandpass ausreichend ist, um eine vorgegebene Resonatormode zu selektieren, da aufgrund des frequenzselektiven Wärmeleitelements der Abstand der im Resonator anschwingenden Moden relativ groß ist. Ein Bandpassfilter mit einem derart breiten Bandpass ist vorteilhaft einfach und kostengünstig herstellbar.

Gemäß zumindest einer Ausführungsform ist das oberflächenemittierende Halbleiterlaser-Bauelement elektrisch pumpbar. Das heißt, elektromagnetische Strahlung wird in der strahlungserzeugenden Schichtenfolge des Halbleiterkörpers durch elektrische Anregung erzeugt. Dazu weist der Halbleiterkörper beispielsweise zwei Kontaktschichten auf, von denen eine auf der Strahlungsdurchtrittsfläche des Halbleiterkörpers angeordnet sein kann. Die Kontaktschicht weist dann eine beispielsweise kreisförmige Ausnehmung auf, durch die im Resonator umlaufende Laserstrahlung treten kann.

Gemäß zumindest einer Ausführungsform ist das oberflächenemittierende Halbleiterlaser-Bauelement optisch gepumpt. Die Pumpquelle kann dazu extern, d. h. entfernt vom Halbleiterkörper, angeordnet sein. Pumpstrahlung tritt von der Pumpstrahlquelle dann vorzugsweise durch die Strahlungsdurchtrittsfläche des Halbleiterkörpers hindurch in die strahlungserzeugende Schichtenfolge ein. Es ist möglich, dass Pumpstrahlung dabei zunächst durch das Wärmeleitelement tritt. Die Pumpstrahlquelle kann dabei z. B. durch einen oder mehrere Diodenlaser gegeben sein.

Weiter ist es möglich, dass die Pumpstrahlung in einer Richtung quer zur Emissionsrichtung des oberflächenemittierenden Halbleiterlaser-Bauelements in die strahlungserzeugende Schichtenfolge geführt ist. Das heißt, das oberflächenemittierende Halbleiterlaser-Bauelement ist lateral gepumpt. In diesem Fall ist es insbesondere auch möglich, dass Pumpstrahlquelle und strahlungsemittierende Schichtenfolge monolithisch auf einem gemeinsamen Träger integriert sind. Das heißt, Pumpstrahlquelle und strahlungserzeugende Schichtenfolge sind z. B. gleichzeitig oder in zeitlicher Abfolge, hintereinander auf ein gemeinsames Aufwachssubstrat epitaktisch abgeschieden.

Es wird darüber hinaus eine optische Projektionsvorrichtung angegeben, die wenigstens ein oberflächenemittierendes Halbleiterlaser-Bauelement, wie es in Verbindung mit den oben aufgeführten Ausführungsformen beschrieben ist, umfasst. Ferner kann die Projektionsvorrichtung beispielsweise eine Ansteuerelektronik zur Ansteuerung des Halbleiterlaser-Bauelements und ein Gehäuse, in das Ansteuerelektronik und Halbleiterlaser-Bauelement integriert sind, aufweisen. Eine solche optische Projektionsvorrichtung eignet sich besonders gut für die Verwendung in einem Multimediaprojektor oder in einem Rückprojektions-Fernsehgerät. Aufgrund seiner kompakten Größe kann eine solche optische Projektionsvorrichtung auch in Kleingeräten wie beispielsweise Mobilfunktelefonen Verwendung finden.

Im Folgenden wird das hier beschriebene Halbleiterlaser-Bauelement anhand von Ausführungsbeispielen und den dazugehörigen Figuren näher erläutert.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.
Figur 1 zeigt eine schematische Schnittdarstellung des hier beschriebenen oberflächenemittierenden Halbleiterlaser-Bauelements gemäß einem ersten Ausführungsbeispiel.
Figur 2 zeigt eine schematische Darstellung der Intensitätsverteilung verschiedener Resonatormoden.
Figur 3 zeigt eine schematische Schnittdarstellung eines nicht zur Erfindung gehörenden Halbleiterlaser-Bauelements.
Figur 4 zeigt eine schematische Schnittdarstellung einer Projektionsvorrichtung gemäß einem Ausführungsbeispiel.

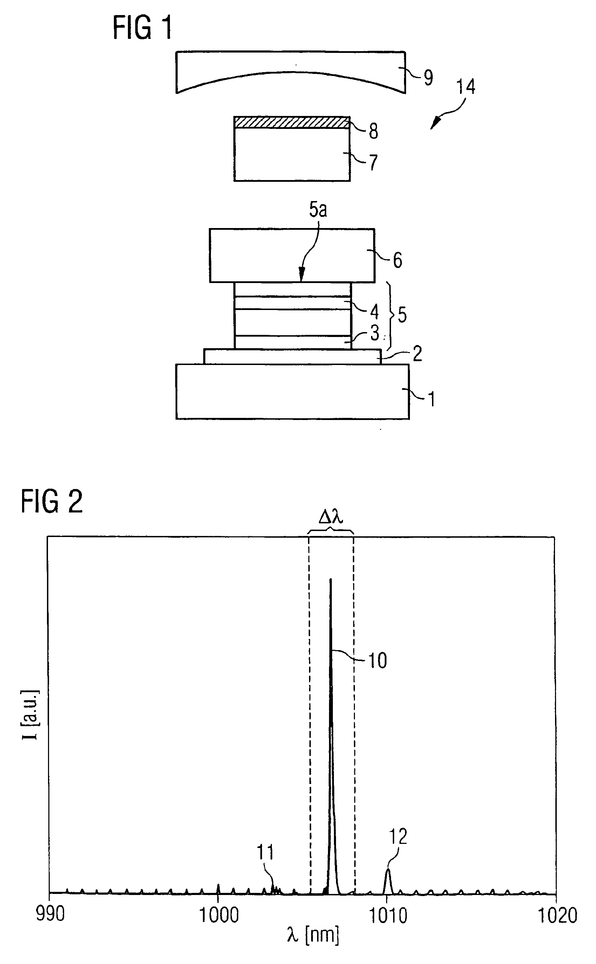

Figur 1 zeigt eine schematische Schnittdarstellung des hier beschriebenen oberflächenemittierenden Halbleiterlaser-Bauelements 14 gemäß einem ersten Ausführungsbeispiel. Das oberflächenemittierende Halbleiterlaser-Bauelement 14 umfasst einen Halbleiterkörper 5. Der Halbleiterkörper 5 enthält unter anderem eine reflektierende Schichtenfolge 3 und eine strahlungserzeugende Schichtenfolge 4.

Bei der strahlungsreflektierenden Schichtenfolge 3 handelt es sich um eine reflektierende Metallschicht, einen Bragg-Spiegel oder um eine Kombination dieser reflektierenden Schichten. Im Ausführungsbeispiel der Figur 1 handelt es sich bei der reflektierenden Schichtenfolge 3 um einen Bragg-Spiegel. Der Bragg-Spiegel weist eine Mehrzahl von Halbleiterschichtenpaaren mit einem vorteilhaft hohen Brechungsindexunterschied auf. Beispielsweise bilden je eine Galliumarsenid- und eine Aluminiumgalliumarsenid-λ/4-Schicht ein Halbleiterschichtenpaar. Die Mehrzahl von Schichtenpaaren im Bragg-Spiegel ist in Figur 1 durch die Schicht 3 schematisch angedeutet. Bevorzugt umfasst der Bragg-Spiegel eine Abfolge von 20 - 30 oder mehr Halbleiterschichtenpaaren, woraus eine besonderes hohe Reflektivität des Bragg-Spiegels von 99,9 % oder mehr resultiert. Mit Vorteil ist der Bragg-Spiegel gemeinsam mit den übrigen Halbleiterschichten des Halbleiterkörpers 5 epitaktisch hergestellt.

Die strahlungserzeugende Schichtenfolge 4 umfasst vorzugsweise einen aktiven Bereich mit einem pn-Übergang, einer Einfach-Quantentopfstruktur oder bevorzugt einer Mehrfach-Quantentopfstruktur, die zur Strahlungserzeugung geeignet ist. Die Bezeichnung Quantentopfstruktur umfasst im Rahmen der Anmeldung insbesondere jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Vorzugsweise basiert die strahlungsemittierende Schichtenfolge 4 auf einem III-V-Verbindungshalbleitermaterial. Das heißt, die strahlungsemittierende Schichtenfolge 4 umfasst mindestens eine Schicht, die aus einem III-V-Verbindungshalbleitermaterial besteht. Bevorzugt basiert die strahlungsemittierende Schichtenfolge 4 auf einem Nitrid-, Phosphid- oder besonders bevorzugt Arsenid-Verbindungshalbleiter.

"Auf Nitrid-Verbindungshalbleitern basierend" bedeutet im vorliegenden Zusammenhang, dass die strahlungsemittierende Schichtenfolge 4 oder zumindest eine Schicht davon ein Nitrid-V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘn-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Phosphid-Verbindungshalbleitern basierend" bedeutet in diesem Zusammenhang, dass die strahlungsemittierende Schichtenfolge 4 oder zumindest eine Schicht davon vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Arsenid-Verbindungshalbleitern basierend" bedeutet in diesem Zusammenhang, dass die strahlungsemittierende Schichtenfolge 4 oder zumindest eine Schicht davon vorzugsweise AlₙGaₘIn₁₋ₙ₋ₘAs umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Diese Materialien zeichnen sich durch vereinfacht erreichbare hohe interne Quanteneffizienzen aus und eignen sich für Strahlung vom ultravioletten (insbesondere Nitrid-basiertes Verbindungshalbleitermaterial) über den sichtbaren (insbesondere Phosphid-basierte Verbindungshalbleitermaterialien) bis in den infraroten Spektralbereich (insbesondere Arsenid-basierte Verbindungshalbleitermaterialien).

Bevorzugt basiert die strahlungserzeugende Schichtenfolge 4 des Halbleiterkörpers 5 auf einem Arsenid-Verbindungshalbleitermaterial. Strahlung im infraroten Spektralbereich, insbesondere im Wellenbereich zwischen 800 nm und 1100 nm, kann in diesem Materialsystem besonders effizient erzeugt werden.

Die Dicke des Halbleiterkörpers 5 beträgt bevorzugt zwischen 5 µm und 8 µm, beispielsweise 7 µm.

Der Halbleiterkörper 5 ist auf einen Träger 1 aufgebracht, beispielsweise aufgelötet. Dazu kann sich zwischen Halbleiterkörper 5 und Träger 1 zum Beispiel eine IR-Lotschicht 2 befinden, die eine Dicke zwischen 4 µm und 6 µm, vorzugsweise 5 µm aufweist. Der Träger 1 besteht bevorzugt aus einem gut Wärme leitenden Material wie beispielsweise einem Kupfer- oder einem Kupferverbundwerkstoff. Die Dicke des Trägers 1 beträgt bevorzugt wenigsten 2 mm, beispielsweise 3 mm.

Weiter weist das oberflächenemittierende Halbleiterlaser-Bauelement 14 einen externen Spiegel 9 auf. Der externe Spiegel 9 ist z. B. konkav gekrümmt. Ferner kann im durch die reflektierende Schichtenfolge 3 und externen Spiegel 9 gebildeten Resonator ein optisch nicht linearer Kristall 7 angeordnet sein, der beispielsweise zur Frequenzverdoppelung der im Resonator umlaufenden Laserstrahlung vorgesehen ist.

Der externe Spiegel 9 weist in diesem Fall für die in der strahlungsemittierenden Schichtenfolge 4 erzeugte elektromagnetische Strahlung eine besonders hohe Reflektivität und für den frequenzkonvertierten Anteil der Strahlung eine hohe Transmittivität auf.

Auf die Strahlungsdurchtrittsfläche 5a des Halbleiterkörpers 5 ist ein Wärmeleitelement 6 aufgebracht. Bei dem Wärmeleitelement 6 handelt es sich um ein Etalon, das beispielsweise Diamant, Siliziumkarbid (SiC) oder andere gut Wärme leitende transparente Materialien enthält oder aus diesen besteht. Das auf die Strahlungsdurchtrittsfläche 5a aufgebrachte Wärmeleitelement bietet gegenüber der rückseitigen Wärmeabfuhr z. B. durch die reflektierende Schichtenfolge 3 den Vorteil, dass die Wärme aus der strahlungserzeugenden Schichtenfolge 4 ohne hohen Wärmewiderstand abgeführt werden kann. Dadurch kann der thermische Widerstand von ca. 100 K/W auf ca. 15 K/W - bei einem angenommenen Pumpstrahldurchmesser von 100 µm im Falle eines externen optisch gepumpten oberflächenemittierenden Halbleiterlasers - gesenkt werden.

Aufgrund der zusätzlichen Mikrokavität des Wärmeleitelements 6, das im Falle eines Diamant- Wärmeleitelements einen Brechungsindex von ca. 2,4 aufweist, ist die vertikale Laseremissionswellenlänge nicht mehr durch den Halbleiterkörper-Luft-Übergang, sondern im Wesentlichen durch den Brechungsindexsprung des Wärmeleitelement-Luft-Übergangs relativ zum Halbleiter-Diamant-Übergang definiert. Der Brechungsindexsprung beim Halbleiter-Luft-Übergang beträgt z. B. ca. 1,2, der Brechungsindexsprung eines Diamant-Luft-Übergangs beträgt ca. 1,4, und der Brechungsindexsprung zwischen Halbleiterkörper 5 und Diamant-Wärmeleitelement 6 beträgt ca. 0,8. Bei einer geeigneten Schichtdicke des Wärmeleitelements 6 von ca. 30 bis 60 µm führt diese Mikrokavität zu einem spektral schmalbandigen Einzelfrequenzbetrieb. Die typische spektrale Laseremission mit einer Halbwertsbreite von ca. 4 nm kann dadurch auf eine Halbwertsbreite von ca. 0,4 nm reduziert sein (siehe dazu auch die Figur 2).

Wie der schematischen Darstellung der Intensitätsverteilung für die transversale Grundmode 10 und zwei höhere Moden 11, 12 in Figur 2 zu entnehmen ist, schwingen im Laserresonator mehrere longitudinale Moden 10, 11, 12 an, deren Abstand umgekehrt proportional zur optischen Dicke des Wärmeleitelements 6 ist.

Aufgrund der geringen spektralen Linienbreite mit einer Halbwertsbreite von höchstens 0,4 nm der vertikalen Laseremission ist damit eine effiziente Frequenzverdoppelung im nicht linearen Kristall 7 ermöglicht, der beispielsweise eine spektrale Akzeptanzbandbreite von ca. 1 nm aufweist. Durch ein optisches Bandpassfilter 8, das als Antireflexionsbeschichtung auf den optisch nicht linearen Kristall 7 aufgebracht ist, kann ein Ausweichen der vertikalen Laseremission auf andere longitudinale Moden 11, 12 unterbunden werden.

Aufgrund des relativ großen spektralen Abstands der longitudinalen Moden 11, 10, 12 (siehe dazu Figur 2), der durch das frequenzselektive resonatorinterne Wärmeleitelement 7 ermöglicht ist, kann ein relativ breitbandiges Bandpassfilter mit einer spektralen Bandbreite Δλ Verwendung finden. Die spektrale Bandbreite Δλ des Bandpassfilters muss dabei geringer als der Abstand zwischen beispielsweise der Grundmode 10 und benachbarten longitudinalen Moden 11, 12 sein. Ein solcher spektral relativ breiter Bandpass kann z. B. als dielektrische Beschichtung ausgeführt sein. Im Ausführungsbeispiel der Figur 1 ist beispielsweise eine Bandbreite Δλ des Bandpassfilters von höchstens 6 nm ausreichend.

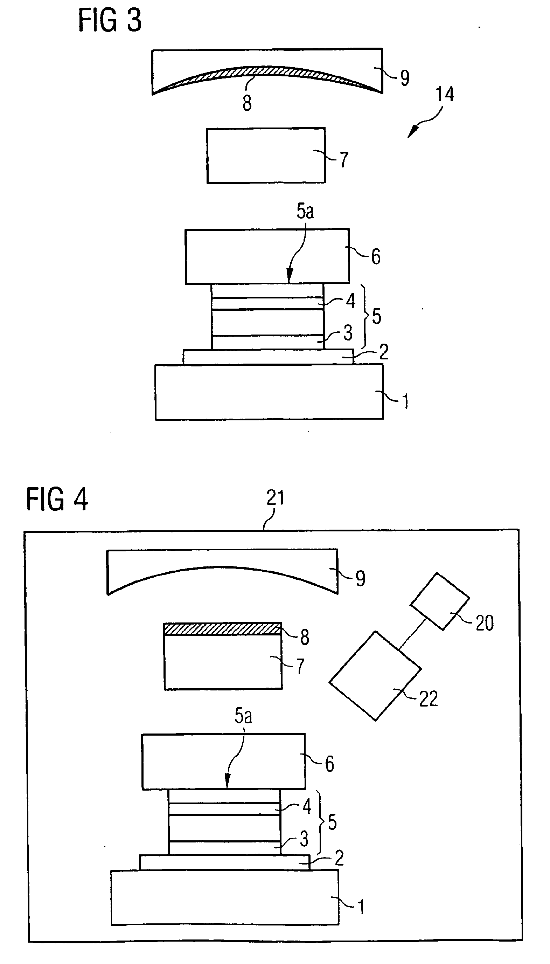

Figur 3 zeigt eine schematische Schnittdarstellung eines nicht zur Erfindung gehörenden Halbleiterlaser-Bauelements 14. Darin ist das optische Bandpassfilter 8 als hochreflektierende Beschichtung auf dem externen Spiegel 9 vorgesehen. Das Bandpassfilter 8 weist dazu beispielsweise eine Reflektivität größer 99,9 % für einen schmalen Wellenlängenbereich Δλ um die Frequenz der Grundmode TEM₀₀ auf.

Figur 4 zeigt eine schematische Schnittdarstellung einer Projektionsvorrichtung gemäß einem Ausführungsbeispiel.

Die optische Projektionsvorrichtung weist wenigstens ein oberflächenemittierendes Halbleiterlaser-Bauelement auf, wie es in Verbindung mit den Figuren 1 und 2 beschrieben ist. In Ergänzung zu einem der oben beschriebenen Halbleiterlaser 14 kann die Projektionsvorrichtung ferner beispielsweise eine Ansteuerelektronik 20 zur Ansteuerung des Halbleiterlasers und ein Gehäuse 21, in das Ansteuerelektronik 20 und Halbleiterlaser 14 integriert sind, aufweisen. Ferner weist der Halbleiterlaser 14 eine Pumpstrahlquelle 22 auf, die geeignet ist, das Halbleiterlaser-Bauelement 14 optisch zu pumpen.

Die gezeigte optische Projektionsvorrichtung eignet sich besonders gut, für die Verwendung in einem MultimediaProjektor oder in einem Rückprojektions-Fernsehgerät. Aufgrund seiner kompakten Größe kann eine solche optische Projektionsvorrichtung auch in Kleingeräten wie beispielsweise Mobilfunktelefonen Verwendung finden.

Die Erfindung ist nicht durch die Beschreibung anhand der Ausführungsbeispiele beschränkt.

Diese Patentanmeldung beansprucht die Prioritäten der deutschen Patentanmeldungen 102005047150.1 und 102005058237.0.

## Patentansprüche

1. Oberflächenemittierendes Halbleiterlaser-Bauelement, mit
- einem Resonator mit einem externen Spiegel (9),
- einem Halbleiterkörper (5), der eine zur Strahlungserzeugung vorgesehene Schichtenfolge (4) umfasst,
- einem transparenten, frequenzselektiven Wärmeleitelement (6), das sich mit einer Strahlungsdurchtrittsfläche (5a) des Halbleiterkörpers (5) in thermischem Kontakt befindet und im Resonator angeordnet ist, wobei das Wärmeleitelement (6) ein Etalon ist und die Dicke des Wärmeleitelements (6) höchstens 60 µm beträgt, und
- einem optischen Bandpassfilter (8), das geeignet ist, vorgebbare Resonatormoden zu unterdrücken,
**dadurch gekennzeichnet, dass**
das Bandpassfilter (8) als Antireflexionsbeschichtung auf ein im Resonator angeordnetes Element aufgebracht ist.

2. Oberflächenemittierendes Halbleiterlaser-Bauelement gemäß dem vorigen Anspruch,
bei dem das Wärmeleitelement (6) eines der folgenden Materialien enthält: Diamant, Siliziumkarbid.

3. Oberflächenemittierendes Halbleiterlaser-Bauelement gemäß Anspruch 1,
bei dem die Dicke des Wärmeleitelements (6) wenigstens 30 µm beträgt.

4. Oberflächenemittierendes Halbleiterlaser-Bauelement gemäß zumindest einem der vorherigen Ansprüche,
bei dem zumindest ein optisch nicht-linearer Kristall (7) im Resonator angeordnet ist.

5. Oberflächenemittierendes Halbleiterlaser-Bauelement gemäß zumindest einem der vorherigen Ansprüche,
bei dem das Bandpassfilter so gewählt ist, dass genau eine Resonatormode, nämlich die transversale Grundmode TEM₀₀ anschwingt.

6. Oberflächenemittierendes Halbleiterlaser-Bauelement gemäß Anspruch 4,
bei dem das Bandpassfilter (8) auf einer Oberfläche des nicht-linearen optischen Kristalls (7) ausgebildet ist.

7. Oberflächenemittierendes Halbleiterlaser-Bauelement gemäß zumindest einem der vorherigen Ansprüche,
bei dem das Bandpassfilter (8) eine Bandbreite von größer 2 Nanometer aufweist.

8. Oberflächenemittierendes Halbleiterlaser-Bauelement gemäß zumindest einem der vorherigen Ansprüche,
bei dem das Halbleiterlaser-Bauelement elektrisch pumpbar ist.

9. Oberflächenemittierendes Halbleiterlaser-Bauelement gemäß zumindest einem der Ansprüche 1 bis 7,
bei dem eine optische Pumpstrahlquelle (22) entfernt vom Halbleiterkörper (5) angeordnet ist.

10. Oberflächenemittierendes Halbleiterlaser-Bauelement gemäß zumindest einem der Ansprüche 1 bis 7,
bei dem die optische Pumpquelle mit dem die strahlungsemittierende Schichtenfolge (4) umfassenden Halbleiterkörper (5) monolithisch auf einem gemeinsamen Träger integriert ist.

11. Optisches Projektionsgerät mit einem Halbleiterlaser-Bauelement (14) gemäß zumindest einem der vorherigen Ansprüche und einer Ansteuerelektronik (20) für das Halbleiterlaser-Bauelements (14).

## Claims

1. Surface-emitting semiconductor laser component, having
- a resonator having an external mirror (9),
- a semiconductor body (5) which comprises a layer sequence (4) which is intended for radiation production,
- a transparent, frequency-selective thermally conductive element (6) which makes thermal contact with a surface (5a) of the semiconductor body (5) through which radiation passes and is arranged in the resonator, with the thermally conductive element (6) being an etalon and the thickness of the thermally conductive element (6) being at most 60 µm, and
- an optical bandpass filter (8) which is suitable for suppression of predeterminable resonator modes, **characterized in that**
the bandpass filter (8) is applied as an antireflective coating to an element arranged in the resonator.

2. Surface-emitting semiconductor laser component according to the previous claim,
in which the thermally conductive element (6) contains one of the following materials: diamond, silicon carbide.

3. Surface-emitting semiconductor laser component according to Claim 1,
in which the thickness of the thermally conductive element (6) is at least 30 µm.

4. Surface-emitting semiconductor laser component according to at least one of the preceding claims,
in which at least one optically non-linear crystal (7) is arranged in the resonator.

5. Surface-emitting semiconductor laser component according to at least one of the preceding claims,
in which the bandpass filter is chosen such that one and only one resonator mode, namely the transversal fundamental mode TEM₀₀, is excited.

6. Surface-emitting semiconductor laser component according to Claim 4,
in which the bandpass filter (8) is formed on one surface of the non-linear optical crystal (7).

7. Surface-emitting semiconductor laser component according to at least one of the preceding claims,
in which the bandpass filter (8) has a bandwidth of more than 2 nanometres.

8. Surface-emitting semiconductor laser component according to at least one of the preceding claims,
in which the semiconductor laser component can be pumped electrically.

9. Surface-emitting semiconductor laser component according to at least one of Claims 1 to 7,
in which an optical pump beam source (22) is arranged remotely from the semiconductor body (5).

10. Surface-emitting semiconductor laser component according to at least one of Claims 1 to 7,
in which the optical pump source is monolithically integrated on a common mount with the semiconductor body (5) which comprises the radiation-emitting layer sequence (4).

11. Optical projection appliance having a semiconductor laser component (14) according to at least one of the preceding claims, and having drive electronics (20) for the semiconductor laser component (14).

## Revendications

1. Composant de laser semi-conducteur à émission de surface, présentant :
- un résonateur doté d'un miroir externe (9),
- un corps semi-conducteur (5) qui comporte une succession de couches (4) prévues pour produire un rayonnement,
- un élément thermoconducteur transparent (6), sélectif en fréquence, en contact thermique avec une surface (5a) traversée par le rayonnement du corps semi-conducteur (5) et disposé dans le résonateur, l'élément thermoconducteur (6) étant un étalon et l'épaisseur de l'élément thermoconducteur (6) étant d'au plus 60 µm,
- et un filtre optique passe-bande (8) qui convient pour inhiber des modes prédéterminés du résonateur, **caractérisé en ce que**
le filtre passe-bande (8) est appliqué en tant que revêtement antiréfléchissant sur un élément disposé dans le résonateur.

2. Composant de laser semi-conducteur à émission de surface selon la revendication précédente, dans lequel l'élément thermoconducteur (6) contient un des matériaux suivants : diamant, carbure de silicium.

3. Composant de laser semi-conducteur à émission de surface selon la revendication 1, dans lequel l'épaisseur de l'élément thermoconducteur (6) est d'au moins 30 µm.

4. Composant de laser semi-conducteur à émission de surface selon au moins l'une des revendications précédentes, dans lequel au moins un cristal optique non linéaire (7) est disposé dans le résonateur.

5. Composant de laser semi-conducteur à émission de surface selon au moins l'une des revendications précédentes, dans lequel le filtre passe-bande est sélectionné de telle sorte qu'exactement un mode de résonateur, c'est-à-dire le mode fondamental transversal TEM₀₀ résonne.

6. Composant de laser semi-conducteur à émission de surface selon la revendication 4, dans lequel le filtre passe-bande (8) est formé sur une surface du cristal optique non linéaire (7).

7. Composant de laser semi-conducteur à émission de surface selon au moins l'une des revendications précédentes, dans lequel le filtre passe-bande (8) présente une largeur de bande supérieure à 2 nanomètres.

8. Composant de laser semi-conducteur à émission de surface selon au moins l'une des revendications précédentes, dans lequel le composant de laser semi-conducteur peut être pompé électriquement.

9. Composant de laser semi-conducteur à émission de surface selon au moins l'une des revendications 1 à 7, dans lequel une source (22) de rayonnement optique de pompage est disposée à distance du corps semi-conducteur (5).

10. Composant de laser semi-conducteur à émission de surface selon au moins l'une des revendications 1 à 7, dans lequel la source de pompage optique est intégrée monolithiquement avec le corps semi-conducteur (5) qui contient la succession (4) de couches émettant un rayonnement sur un support commun.

11. Appareil de projection optique doté d'un composant (14) de laser à semi-conducteur selon au moins l'une des revendications précédentes et une électronique de commande (20) du composant (14) de laser à semi-conducteur.
